# FASCICULE DE BREVET EUROPEEN

(11) **EP 1 052 772 B1**
(45) Date de publication et mention de la délivrance du brevet: **14.04.2004**
(21) Numéro de dépôt: 00401203.5
(22) Date de dépôt: 02.05.2000
(51) Int. Cl.: H03J 3/32, H03J 3/08, H03J 3/28, H04B 1/04

(54) **Dispositif et procédé pour produire un signal filtré**
Schaltung und Verfahren zur Erzeugung eines gefilterten Signals
Circuit and method for producing a filtered signal

(30) Priorité: 10.05.1999 FR 9905922
(43) Date de publication de la demande: 15.11.2000
(73) Titulaire: ALCATEL, 75008 Paris (FR)
(72) Inventeur: Berland, Corinne, 75010 Paris (FR); Yang, Fuji, 92110 Clichy (FR); Guerlin, Jean-Pierre, 95130 Le Plessis Bouchard (FR)
(74) Mandataire: Lamoureux, Bernard

(56) Documents cités:
- EP-A- 0 779 707
- GB-A- 2 238 193
- US-A- 4 817 193

## Description

La présente invention concerne de manière générale un circuit et un procédé pour produire un signal filtré ayant une fréquence donnée.

L'invention s'applique notamment, mais non exclusivement, au domaine de la radio-télécommunication pour la réalisation d'émetteurs dont le signal modulé est filtré et dont la fréquence d'émission (c'est-à-dire la fréquence de la porteuse) est établie par un oscillateur à fréquence variable réglé à cette fréquence d'émission.

Il est maintenant connu d'employer dans un émetteur hertzien un circuit oscillateur, tel qu'un oscillateur à fréquence commandé en tension (dénommé VCO ci-après) monté en boucle à verrouillage de phase, pour engendrer directement un signal oscillant à la fréquence de la porteuse. Dans un tel montage, on n'utilise pas d'étages à fréquences intermédiaires pour engendrer la porteuse, comme dans le cas d'un circuit superhétérodyne classique. C'est pour cette raison que ces émetteurs sont connus sous le terme "d'émetteur sans fréquence intermédiaire", ou "d'émetteur zéro-IF".

On utilise les émetteurs sans fréquence intermédiaire entre autres pour les circuits émetteur/récepteur hyperfréquence destinés aux terminaux de téléphones mobiles.

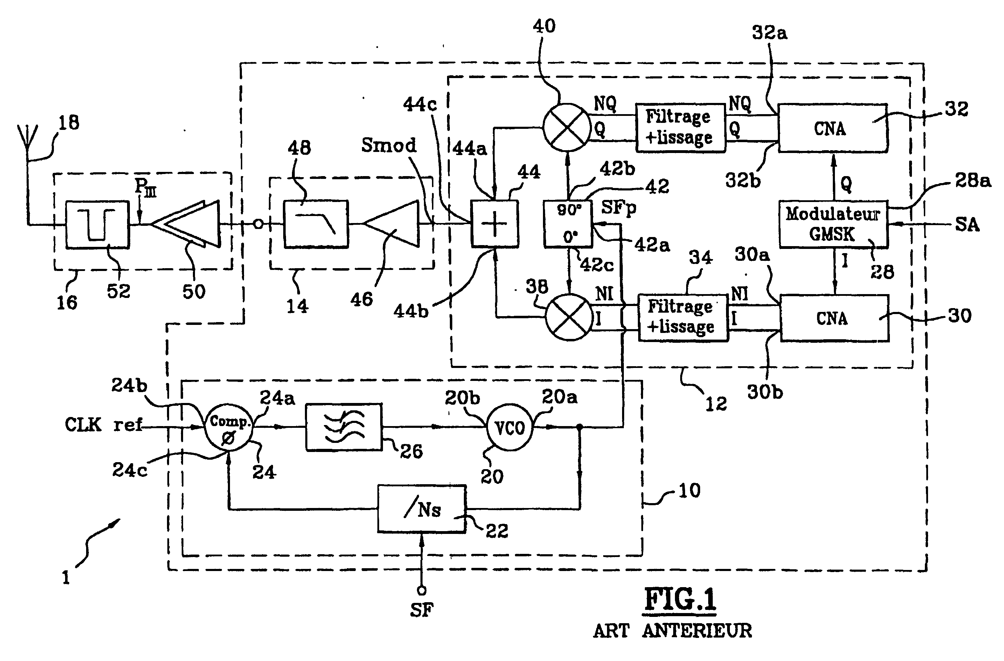

La figure 1 représente les principaux éléments fonctionnels d'un émetteur sans fréquences intermédiaires connu, tel qu'utilisé dans les terminaux émetteur/récepteur de téléphonie mobile.

L'émetteur 1 comporte une générateur de fréquences programmable 10 qui délivre un signal SFp à la fréquence porteuse Fp, un étage 12 de modulation à déplacement minimum et filtrage gaussien en amont, également connue sous le terme de modulation GMSK (Gaussian Minimum Shift Keying), un étage 14 de préamplification et de préfiltrage du signal modulé Smod et un étage 16 d'amplification de puissance et de filtrage passe-bas délivrant le signal modulé sur une antenne d'émission 18.

Le générateur de fréquences 10 comporte de manière dassique un oscillateur commandé en tension (VCO) 20, un diviseur de fréquence programmable 22, un comparateur de phases 24 et un filtre passe-bas 26 montés en boude à verrouillage de phase (dénommé PLL ci-après).

L'oscillateur commandé en tension 20 produit à sa sortie 20a un signal dont la fréquence Fp est proportionnelle à la tension Vref présentée à son entrée 20b. Cette conversion de tension en fréquence est réalisée par un circuit résonnant à fréquence de résonance électriquement variable, couplé à un amplificateur à rebouclage positif. La fréquence du signal en sortie de l'oscillateur 20 correspond à la fréquence de résonance du circuit résonnant. Ce circuit résonnant est généralement du type inducteur-capacité (LC).

Afin de permettre de régler la fréquence de résonance de l'oscillateur 20, la partie capacitive du circuit résonnant est réalisée avec au moins une diode ayant une capacité qui varie en fonction de sa tension de polarisation. Ces diodes à capacité variable sont connues sous le terme de diodes "varicap" ou de varactors.

Ainsi, la tension de commande Vref présentée à l'entrée 20b du VCO est appliquée à une ou à plusieurs des diodes précitées pour modifier la fréquence de résonance du circuit résonnant.

Cette tension de commande Vref est produite à la sortie 24a du comparateur de phases 24 et transmise au VCO 20 par l'intermédiaire du filtre passe-bas 26. Elle exprime la différence de phase entre deux signaux présentés respectivement à une première et une deuxième entrées de comparaison 24b et 24c du comparateur de phases. La première entrée de comparaison 24b reçoit un signal de référence clk ref ayant une fréquence Fref étalonnée et stabilisée, provenant par exemple d'un oscillateur à quartz. La deuxième entrée de comparaison 24c reçoit en rebouclage le signal de sortie du VCO 20, dont la fréquence a été divisée par un nombre programmable N par le diviseur de fréquences 22.

Le comparateur de phase 24 comprend un circuit de pompage de charge associé à un condensateur de manière à produire à so sortie 24a une tension qui croît ou qui décroît selon que le signal du VCO divisé en fréquence est respectivement en retard ou en avance de phase par rapport au signal de référence clk ref.

En recevant la tension Vref du comparateur de phases 24, le VCO 20 tend ainsi à produire une fréquence qui, lorsque divisée par N par le diviseur de fréquences 22, est calée sur la fréquence du signal de référence clk ref. Le VCO 20 se stabilise lorsque le comparateur 24 ne détecte aucun déphasage sur ses deux entrées de comparaison 24b, 24c et produit alors une tension Vref constante.

Dans ce mode stabilisé, on a la condition d'égalité des fréquences aux deux entrées de comparaison, soit : Fref = Fp/N, d'où la fréquence de sortie de l'oscillateur Fp = N.Fref.

Ainsi, on règle la fréquence de sortie du VCO 20 en variant la valeur de N programmé dans le diviseur de fréquences 22, cette valeur agissant comme coefficient variable. La valeur de N est établie par des données numériques SF de sélection de fréquence présentées à l'entrée de programmation du diviseur de fréquence 22.

Le filtre passe-bas 26 a pour rôle d'empêcher que les variations de tension trop rapides ne soient transmises sur le VCO 20, celles-ci pouvant mettre la boucle d'asservissement en phase en régime instable. De telles variations peuvent apparaître notamment lorsqu'une nouvelle fréquence est programmée au niveau du diviseur 22. La fréquence de coupure du filtre passe-bas 24 est donc fixée par rapport à la bande passante de la boucle en régime stable.

Conformément à la conception d'un émetteur sans fréquences intermédiaires, le signal SFp du circuit PLL 10, prélevé à la sortie 20b du VCO, est utilisé dans l'étage de modulation 12 pour fournir la porteuse du signal d'émission.

L'étage de modulation 12 reçoit en entrée un signal SA destiné à moduler la porteuse SFp selon la technique précitée de modulation à déplacement minimum et filtrage gaussien en amont (dénommé ci-après modulation GMSK). Les aspects spécifiques à ce type de modulation peuvent être trouvés dans l'ouvrage "The GSM System for Mobile Communications", Chapitre 4, pages 250-255 par Michel Mouly et Marie-Bernadette Pautet, publié en 1992 par les auteurs sous la référence ISBN 2-9507190-0-7, ou dans l'article de K.Murota "GMSK modulation for digital mobile radiotelephony", IEEE Transactions on Communications, Vol.Com.29, No.7, juillet 1981, pages 1044-1050.

Le signal SA, qui peut être un signal audio issu d'un combiné de téléphone mobile, est présenté sous forme numérisée à une entrée de modulation 28a d'un modulateur GMSK 28. De manière bien connue, le modulateur GMSK 28 sur-échantillonne le signal numérique SA afin de déterminer l'évolution de la phase de ce signal à des instants successifs. Cette évolution de la phase est exprimée par deux signaux numériques I et Q qui indiquent respectivement le cosinus et le sinus de la phase à des instants successifs. Chacun de ces signaux I et Q est transmis vers un convertisseur numérique-analogique respectif 30 et 32 où il est converti en forme d'onde analogique sur deux voies avec une paire différentielle. Ainsi, le convertisseur numérique-analogique 30 reproduit sur ses deux sorties 30a, 30b la même information mais avec des signaux analogiques NI et I déphasés de 180° l'un par rapport à l'autre. De même, le convertisseur numérique-analogique 32 reproduit sur ses deux sorties 32a, 32b la même information, mais avec des signaux analogiques NQ et Q déphasés de 180° l'un par rapport à l'autre. Cette sortie sous forme différentielle permet notamment d'effacer des bruits parasites de mode commun apparaissant dans les formes d'onde après la conversion.

Après un filtrage et un lissage par des circuit respectifs 34 et 36, les deux paires de signaux différentielles NI, I, et NQ, Q sont combinées avec le signal SFp issu de l'étage PLL 10 pour produire le signal d'émission modulé Smod.

Ce signal Smod possède un spectre centré sur la fréquence Fp de la porteuse, modulé en fréquence en fonction du signal SA.

A cette fin, l'étage de modulation 12 comporte en outre un premier et un deuxième mélangeurs à trois voies 38 et 40, un générateur de quadrature de phase 42 et un circuit de combinaison 44.

Le générateur de quadrature de phase 42 reçoit sur son entrée 42a le signal à la fréquence porteuse Fp du PLL 10 pour le reproduire sur deux sorties, 42b, 42c respectivement avec un décalage de phase de 90° et sans décalage d'amplitude.

Le premier mélangeur 38 reçoit sur ses trois voies respectivement le signal SFp sans décalage et les signaux différentiels NI et I. De même, le deuxième mélangeur 40 reçoit sur ses trois voies respectivement le signal SFp décalé de 90° et les signaux différentiels NQ et Q. La sortie mélangée de chacun des deux mélangeurs 38 et 40 est présentée à une entrée respective 44a, 44b du circuit de combinaison 44 afin d'en obtenir à la sortie 44c le signal Smod modulé en GMSK sur la fréquence porteuse Fp.

Ce signal modulé Smod est transmis à l'étage de préamplification et de préfiltrage 14.

Cet étage 14 comporte un préamplificateur 46, qui reçoit directement le signal modulé Smod, et un filtre passe-bas 48 relié à la sortie du préamplificateur. Le préamplificateur a pour rôle d'élever le niveau du signal modulé à un niveau suffisant pour attaquer l'étage d'amplification en puissance 16. Le filtre passe-bas 48 réalise un pré-filtrage pour atténuer les composantes parasites ayant deux ou trois fois la fréquence du signal Fp de la porteuse.

Après passage à travers le filtre passe-bas 14, le signal Smod est transmis à l'étage d'amplification de puissance 16. Cet étage comprend un amplificateur de puissance 50 qui reçoit le signal Smod issu du filtre 14, et un filtre passe-bas avec un rejecteur de bande RX 52 à la sortie de l'amplificateur. Le filtre passe-bas 52 a pour rôle d'atténuer les composantes de bruit dans la signal Smod amplifié qui se situent en dehors de la bande Tx de transmission admise. La sortie du filtre 52 attaque l'antenne d'émission 18.

Avec ce type d'émetteur, l'élimination du bruit d'émission à des fréquences en dehors de la bande d'émission Tx est un problème important, comme on le comprendra d'après l'exemple qui suit, pris dans le cas d'un terminal de téléphonie mobile à la norme GSM.

Un tel terminal émet sur un canal d'une bande de transmission bien définie, dénommée la bande Tx, et reçoit sur un canal d'une bande de réception, dénommée la bande Rx, pour réaliser une liaison téléphonique en duplex.

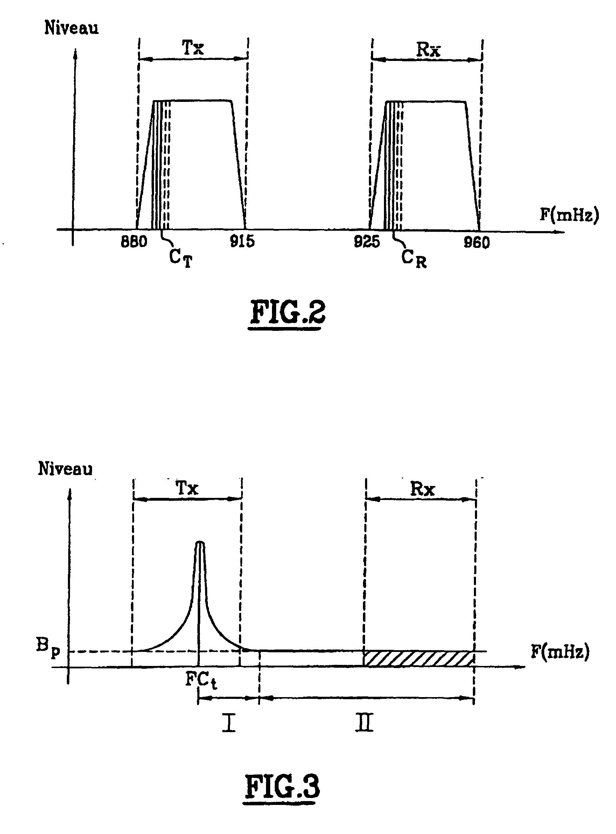

La figure 2 représente les bondes de fréquences de transmission Tx et de réception Rx de la norme GSM. La bande de transmission Tx se situe entre 880 et 915 MHz, et la bande de réception Rx se situe entre 925 et 960 MHz. Chacune de ces bandes est divisée en canaux de transmission ou de réception Ct, Cr, à raison d'un canal tous les 200 kHz. En conversation, le téléphone mobile émet sur l'un des canaux Ct de la bande Tx vers une station de base locale et reçoit depuis cette station la voix de l'interlocuteur sur l'un des canaux Cr de la bande Rx. Les canaux Ct et Cr sont alloués ponctuellement par la station de base en fonction des conditions d'utilisation, et sont susceptibles de changer lors d'une communication. Lorsque la station de base commande au terminal un changement de canal d'émission Ct, la nouvelle fréquence correspondante est aussitôt programmée par les données SF de programmation en entrée du diviseur de fréquence 22 de la boucle PLL 10, de sorte que celle-ci effectue un saut vers la fréquence porteuse de ce nouveau canal.

Il importe de contenir autant que possible le spectre du signal d'émission Smod au sein canal de transmission Ct alloué, et notamment de ne pas laisser le spectre d'émission s'étendre aux fréquences de la bande de réception Rx.

La figure 3 représente le spectre du signal d'émission Smod à la sortie de l'amplificateur de puissance 50 de la figure 1 avant le filtre 52 (point PIII). La fréquence est représentée en abscisse à la même échelle pour la figure 2, et le niveau de puissance en ordonnée.

La fréquence d'émission (c'est-à-dire la fréquence Fp de la porteuse) est calée sur la fréquence Fp du canal alloué, où le spectre est au maximum. On ne considère ici que le spectre pour les fréquences supérieures à Fp.

Le niveau du signal d'émission Smod baisse rapidement au fur et à mesure que la fréquence augmente sur une plage restreinte de fréquences I qui jouxte la fréquence d'émission Fp. La présence non voulue du signal dans cette plage de fréquence I en dehors du canal Fp constitue ce que l'on appel le bruit de phase. Lorsque l'on s'approche de la limite supérieure de cette plage I, le bruit diminue moins rapidement pour atteindre un niveau de bruit quasi constant Bp, appelé "bruit de plancher", qui subsiste sur une plage de fréquences II s'étendant loin dans le spectre. On remarque que ce bruit de plancher Bp persiste notamment aux fréquences de la bande de réception Rx (partie hachurée du spectre).

Les normes de communication imposent des mesures strictes pour minimiser la présence du bruit de plancher, surtout dans la bande de réception Rx.

La présence du filtre passe-bas passif 52 en sortie de l'amplificateur de puissance 50 est la solution retenue dans l'état de la technique pour atténuer le bruit plancher dans la bande de réception Rx. Les caractéristiques du filtre sont alors étudiées pour favoriser l'atténuation dans la moitié du spectre située au-delà de la fréquence d'émission, c'est-à-dire du côté où se situe la bande d'émission Rx. De ce fait, ces filtres ont une réponse asymétrique autour de la fréquence d'émission.

Dans la pratique, on a couramment recours pour ce filtrage à des filtres à onde de surface (FOS), aussi connu par le terme de filtre SAW.

Dans le contexte actuel, les filtres SAW offrent les meilleurs caractéristiques de filtrage, notamment dans le domaine des hyperfréquences. Cependant, la solution basée sur un tel filtre comporte plusieurs inconvénients.

Un premier inconvénient résulte du fait que, pour des raisons qui seront données plus loin, il est indiqué de placer le filtre 52 à la sortie, plutôt qu'en amont, de l'amplificateur de puissance 50. Ceci a pour conséquence d'entraîner une perte de puissance sensible du signal entre la sortie de l'amplificateur de puissance 50 et l'antenne 18, une partie du signal amplifié étant absorbée par les éléments internes du filtre 52. Ainsi, pour obtenir à l'antenne 18 un niveau de signal spécifié par la norme GSM, l'adjonction du filtre 52 nécessite d'augmenter la puissance de l'amplificateur, et donc la consommation globale de l'émetteur. Dans les applications en téléphonie mobile où l'émetteur fonctionne avec des batteries, ce surcroît de consommation se traduit directement par une diminution de l'autonomie en temps de communication du terminal mobile.

Si, pour éviter ce problème, on plaçait le filtre 52 en amont de l'amplificateur de puissance 50 afin que les pertes du filtre n'interviennent que sur des signaux de faible puissance, le bruit de plancher Bp ne serait pas correctement atténué.

En effet, la transmission s'effectuant en modulation de fréquence, l'amplificateur de puissance 50 fonctionne en mode saturé, c'est-à-dire à amplitude constante. Or, dans ce mode, l'amplificateur 50 tend à rendre son spectre de sortie symétrique autour de la fréquence centrale d'émission par un effet de repliement de spectre. Il en résulte que le bruit dans la moitié du spectre se situant aux fréquences inférieures à la fréquence centrale d'émission, qui n'est pas ou peu filtrée, se retrouve à la sortie de l'amplificateur de puissance aussi dans la moitié du spectre se situant aux fréquences au-delà de la fréquence d'émission centrale, qui a été filtrée préférentiellement.

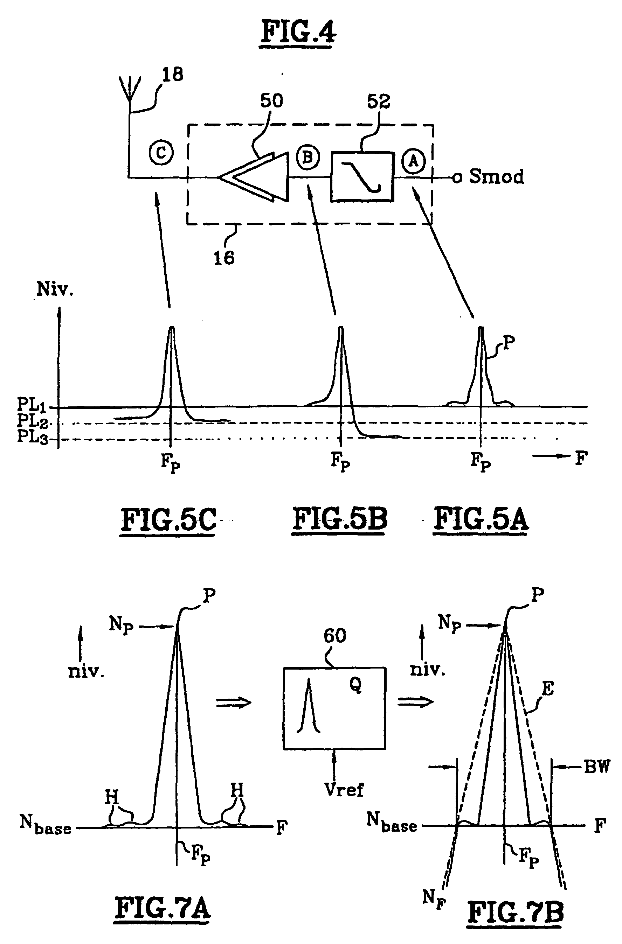

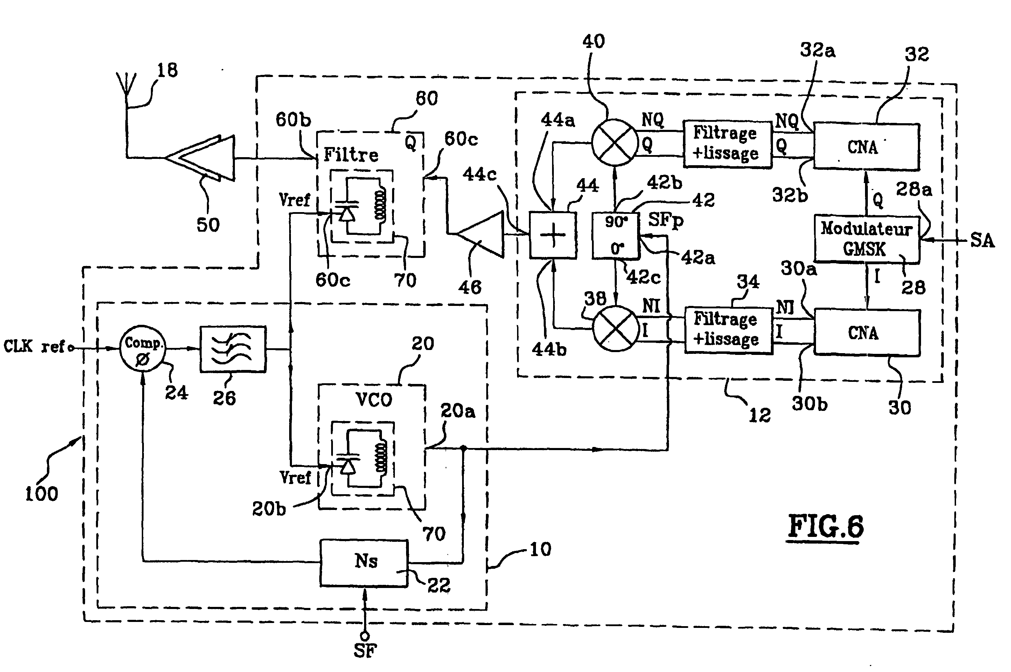

Ce phénomène de repliement de spectre d'émission par l'amplificateur fonctionnant en mode saturé est illustré par les figures 4 et 5.

La figure 4 représente l'étage d'amplification et de filtrage 16 de la figure 1 modifié en ce que le filtre passif 52 est monté en amont de l'amplificateur du puissance 50.

Les figures 5A à 5C représentent la forme du spectre du signal d'émission Smod, avec l'amplitude en ordonnée et la fréquence en abscisse, respectivement avant le filtre 52, entre le filtre et l'amplificateur de puissance 50 et à la sortie ce dernier.

On constate à la figure 5A que le signal Smod issu du modulateur GMSK avant filtrage est symétrique et présente un pic à la fréquence centrale d'émission Fp. En dehors de ce pic P, le niveau atteint rapidement un niveau de plancher de bruit situé à une valeur PI1.

Après le filtrage, le niveau de plancher de bruit de la moitié du spectre se situant aux fréquences au-delà de la fréquence Fp est atténué par la filtre passe-bas 52 pour atteindre à une valeur PI3 < PI1. On remarque que ce filtrage n'est pas symétrique autour de la fréquence centrale d'émission Fp, la moitié du spectre se situant aux fréquences en dessous de la fréquence Fp n'étant guère atténuée (figure 5B). En effet, le filtre passif 52 est surtout optimisé pour éliminer le bruit dans la bande de réception Rx, qui se situe à des fréquences plus élevées que la bande de transmission Tx (cf. figure 2).

Lors du passage dans l'amplificateur de puissance 50 en mode saturé, le signal filtré subit un repliement de spectre comme expliqué plus haut, qui fait que le niveau de bruit non filtré à la moitié du spectre se situant aux fréquences en dessous de la fréquence Fp se reflète sur la partie du partie du spectre se situant aux fréquences au-dessus de cette fréquence Fp. Ainsi, comme le montre la figure 5C, la moitié du spectre se situant au-dessus de la fréquence central d'émission Fp récupère le bruit de l'autre moitié du spectre et présente alors un niveau de bruit de plancher situé autour d'une valeur PI2 intermédiaire entre les niveaux P1 et P3 précités. Ainsi, l'effet de repliement de l'amplificateur 50 entraîne une dégradation du rapport signal bruit du signal d'émission Smod, du fait de l'asymétrie de ce dernier, aux fréquences élevées.

Un second inconvénient provient de l'encombrement du filtre 50, notamment lorsque celui-ci est un dispositif SAW précité. En effet, ce genre de filtre, qui met en oeuvre des phénomènes acoustiques, doit être réalisé sous forme de composant logé dans un boîtier spécifique et qui ne se prête pas la miniaturisation. Cet encombrement et d'autant plus pénalisant que tous les autres éléments d'un émetteur tel que représenté à la figure 1 peuvent être réalisés sous forme de circuit intégré.

Enfin, il est toujours difficile de respecter les normes de transmission en matière de limitation du bruit dans la bande d'émission Rx, même en utilisant les filtres à onde de surface performant, placés en sortie de l'amplificateur de puissance pour éviter le phénomène de repliement de spectre.

Au vu de ces problèmes, la présente invention propose un circuit pour produire un signal à une fréquence donnée avec filtrage, comprenant un oscillateur réglable pour osciller à cette fréquence donnée au moyen d'un signal de commande de fréquence d'oscillation et au moins un filtre réglable pour s'accorder à cette fréquence donnée, le réglage en fréquence de ce filtre étant réalisé à partir du signal de commande de fréquence de l'oscillateur.

Ainsi, on utilise un même signal de commande à la fois pour établir la fréquence d'oscillation de l'oscillateur et pour accorder le filtre à cette fréquence.

Avantageusement, le filtre est un filtre actif.

Le filtre peut être du type passe-bande, dons lequel cas la fréquence à laquelle il est accordé par le signal de commande correspond à sa fréquence centrale de passage de signal.

Le filtre peut aussi être un filtre à entaille ou à coupure de bande, dans lequel cas la fréquence à laquelle il est accordé par le signal de commande correspond à la fréquence d'entaille ou de coupure.

Le filtre peu également être un filtre passe-haut ou passe-bas, dans lequel cas la fréquence à laquelle il est accordé correspond à la fréquence de coupure.

Ce circuit peut être mis en oeuvre avantageusement dans un dispositif émetteur hertzien, par exemple un émetteur du type sans fréquences intermédiaires, émettant à une fréquence d'émission donnée, l'émetteur comprenant un moyen formant oscillateur réglable par un signal de commande fréquence pour osciller à cette fréquence d'émission, et au moins un filtre pour filtrer le signal modulé, l'émetteur étant caractérisé en ce que le filtre est réglable en fréquence de manière à pouvoir s'accorder à la fréquence d'émission, le réglage en fréquence de ce filtre étant réalisé à partir du signal de commande de fréquence de l'oscillateur.

Grâce à cette conception, il est possible d'obtenir un filtrage du signal ayant la fréquence donnée, ici le signal d'émission modulé, avec une fréquence de filtrage qui est accordé en permanence à la fréquence de l'oscillateur.

Ainsi, pour le cas de l'émetteur précité, on obtient un filtrage optimal du signal d'émission quelle que soit la fréquence d'émission instantanée. Le filtre utilisé réglable pour l'émetteur est avantageusement un filtre passe-bande. Dans ce cas, l'invention permet d'employer un filtre passe-bande à facteur de qualité Q élevé, c'est-à-dire à bande de passage de signal très étroite autour d'une fréquence centrale réglable, calée sur la fréquence d'émission, afin d'exclure les composantes non voulues en dehors de cette fréquence. En effet, le fait que la fréquence centrale de passage du filtre soit réglable et accordée directement à la fréquence de transmission (porteuse), permet de choisir des caractéristiques de filtrage pointues autour de cette fréquence. Il en résulte que l'on obtient un excellent rejet des signaux parasites.

A contrario, le filtre passe-bande employé dans les émetteurs de l'état de la technique, n'étant pas réglable, doit avoir une bande passante suffisamment large pour laisser passer le signal sur toute la bande de transmission Tx sans atténuation sensible. De ce fait, les signaux parasites, y compris ceux dans la plage de fréquence de la bande de réception Rx, ne sont pas bien atténués avec le filtrage de l'état de la technique.

De préférence, le filtre réglable en fréquence présente une courbe de réponse sensiblement symétrique autour de la fréquence centrale.

Le cas d'une mise en oeuvre d'un filtre réglable conformément à l'invention permet de placer ledit filtre en amont de l'amplificateur de puissance de l'émetteur, et donc d'éviter les pertes de puissance liées à la présence d'un filtre à la sortie de l'amplificateur de puissance.

En effet, lorsque l'on utilise un filtre passe-bande ayant une courbe de réponse symétrique, on atténue aussi les bien fréquences en-dessous de la fréquence centrale que les fréquences au-dessus de cette fréquence. Le signal modulé en sortie du filtre n'est donc pas affecté par le phénomène de repliement de l'amplificateur de puissance fonctionnant en mode saturé.

Le moyen formant oscillateur peut comprendre un oscillateur à fréquence asservi en tension. Dans ce cas, le signal de commande de fréquence se présente sous la forme d'une tension.

De préférence, le moyen formant oscillateur est réalisé sous forme de boucle à verrouillage de phase, dans lequel cas le signal de commande de fréquence est fourni par un comparateur de phase.

Avantageusement, le filtre est réalisé sous forme de circuit intégré, permettant ainsi de réduire l'encombrement de l'émetteur par rapport à la technique antérieure basée sur des filtres passifs, tels que les filtres à onde de surface nécessitant des boîtiers spécifiques.

De préférence, le filtre actif et l'oscillateur précités sont tous les deux réalisés sous forme de circuit intégré sur un même substrat. Cette disposition permet en outre d'accorder avec précision la fréquence du filtre avec la fréquence du signal de sortie de l'oscillateur.

A cette fin, on peu prévoir pour le filtre et l'oscillateur des moyens de conversion du signal de commande de fréquence en paramètre agissant sur la caractéristique de fréquence, réalisés selon les mêmes règles de conception, de manière à assurer que le filtre soit accordé fidèlement à la fréquence de l'oscillateur.

De préférence, les moyens de conversion du signal de commande de fréquence en paramètre agissant sur la caractéristique de fréquence comprennent au moins un circuit résonnant ayant au moins un composant dont une caractéristique varie en fonction du signal de commande qui lui est présenté. Dans ce cas, le circuit résonnant du filtre et le circuit résonnant de l'oscillateur pourront avoir la même configuration.

Le circuit résonnant peut être réalisé à partir d'éléments inductifs et capacitifs formant un circuit LC, et/ou d'éléments résistifs et capacitifs formant un circuit RC. L'un au moins du ou des élément(s) capacitif(s) peut être une diode dont la capacité est variable en fonction de la tension de polarisation de la diode. Dans ce cas, le signal de commande peut être une tension destinée à polariser la diode à capacité variable.

A titre d'exemple, le condensateur peut être une diode du type "varactor" ou "varicap".

L'invention concerne également un appareil de téléphone mobile comprenant un dispositif émetteur hertzien du type précité.

L'invention concerne également un procédé pour produire un signal à une fréquence donnée avec filtrage, comprenant l'étape de régler un oscillateur réglable au moyen d'un signal de commande de fréquence d'oscillation pour le faire osciller à cette fréquence donnée et l'étape de régler au moins un filtre réglable afin que celui-ci soit accordé à cette fréquence donnée, le réglage en fréquence de ce filtre étant réalisé à partir du signal de commande de fréquence de l'oscillateur.

Ce procédé peut être mis en oeuvre avantageusement dans un dispositif émetteur hertzien, par exemple un émetteur du type sans fréquences intermédiaires, dans lequel on module un signal à une fréquence d'émission fourni par un moyen formant oscillateur réglable au moyen d'un signal de commande fréquence pour osciller à cette fréquence d'émission, le signal modulé étant filtré par des moyens comprenant au moins un filtre réglable en fréquence pour s'accorder à la fréquence d'émission, le réglage en fréquence de ce filtre étant réalisé au moyen du signal de commande de fréquence de l'oscillateur.

D'autres avantages et caractéristiques de l'invention apparaîtront à la lecture de la description d'un mode de réalisation préféré, donnée purement à titre d'exemple, par référence aux dessins annexés dont :
- la figure 1, déjà présentée, est un schéma bloc d'un dispositif émetteur sans fréquence intermédiaire de l'état de la technique;
- la figure 2, déjà présentée, est un schéma illustrant les bandes d'émission et de réception utilisées dans la téléphonie mobile à la norme GSM;
- la figure 3, déjà présentée, illustre le spectre d'émission de l'émetteur de la figure 1 vis-à-vis des bandes d'émission et de réception de la figure 2;
- la figure 4, déjà présentée, illustre un montage hypothétique de l'étage de filtrage et d'amplification en puissance de l'émetteur de la figure 1;
- les figures 5A, 5B et 5C, déjà présentées, illustrent le spectre du signal modulé de l'émetteur à trois points respectifs de l'étage représenté à la figure 4;
- la figure 6 est un schéma bloc d'un dispositif émetteur sans fréquences intermédiaires conformément à l'invention;
- les figures 7A et 7B illustrent le spectre d'émission de l'émetteur de la figure 6 respectivement avant et après filtrage par un filtre passe-bande; et

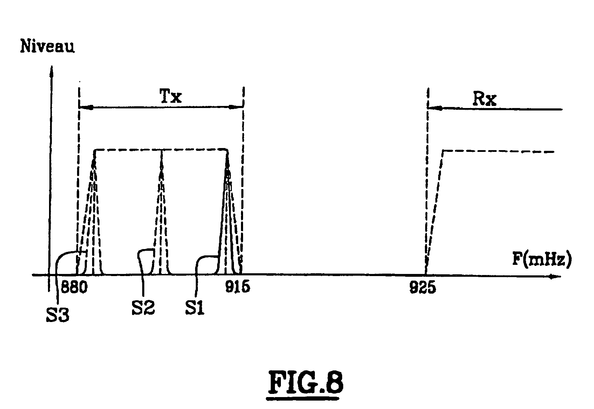

- la figure 8 illustre le positionnement de spectre d'émission de l'émetteur de la figure 6 vis-à-vis de la bande de transmission exploité par l'émetteur.

Il sera maintenant décrit par référence à la figure 6 un exemple de réalisation de l'invention basé sur un émetteur sans fréquence intermédiaire, destiné notamment à un terminal de téléphone mobile.

Les parties de cet émetteur qui sont identiques à celles de l'émetteur de la figure 1 portent les mêmes repères et ne seront pas décrites à nouveau par souci de concision; leurs fonctions et caractéristiques pourront être comprises d'après les sections pertinentes de la description de la figure 1.

L'émetteur 100 comporte oscillateur à fréquence réglable 10 basé sur une boucle à asservissent de phase (PLL) comprenant un oscillateur commandé en tension 20, un diviseur par N programmable 22, un comparateur de phases 24 et un filtre passe-bas 26 selon un montage classique comme décrit précédemment par référence à la figure 1. La fréquence Fp de l'oscillateur peut donc être varié par programmation au niveau du diviseur de fréquences 22 au moyen des données SF fixant la valeur du diviseur N, comme expliqué plus haut par référence à la figure 1. La fréquence d'émission Fp est ainsi changée de manière dynamique pour suivre les changements de canal d'émission nécessaires au cours d'une communication, ces changements étant commandés par une station de base en fonction des conditions de transmission.

L'oscillateur 10 produit directement le signal d'émission SFp à la fréquence porteuse Fp de l'émetteur, conformément à la conception des émetteurs sans fréquences intermédiaires.

Ce signal SFp est transmis à un étage 16 de modulation à déplacement minimum et filtrage gaussien en amont (GMSK) tel que décrit par référence à la figure 1, où il est mélangé avec un signal audio SA contenant l'information à transmettre sous forme numérique.

Le signal modulé Smod issu de l'étage de modulation 12 est transmis à un préamplificateur 46 ayant pour rôle de le mettre à un niveau et à une impédance adaptés pour attaquer un amplificateur de puissance 50.

L'émetteur comprend un étage de filtrage à fréquence de réglable par un signal de commande Vref qui est le même que celui qui commande la fréquence de l'oscillateur 10. Ainsi, la fréquence centrale de passage de signal du filtre 60 évolue de manière dynamique afin de rester toujours accordée à la fréquence d'émission, qui varie en fonction des canaux de transmission utilisés ponctuellement lors de l'émission.

Dans l'exemple, cet étage de filtrage comprend un filtre actif passe-bande 60 dont l'entrée de filtrage 60a reçoit le signal modulé Smod tel qu'il apparaît à la sortie du préamplificateur 46.

La sortie 60b du filtre 60 fournit le signal filtré à l'entrée de l'amplificateur de puissance 50.

L'ensemble des éléments constitutifs de l'émetteur 100 (hormis l'antenne 18) peut être réalisé sous forme de circuit intégré. Il est notamment possible de réaliser le filtre et l'oscillateur sur un même substrat.

Le filtre actif 60 permet un réglage de sa fréquence centrale de passage grâce à un circuit résonnant 70 à fréquence de résonance électriquement variable dans son circuit de filtrage. Ainsi, lorsque le filtre 60 est réglé à une fréquence de filtrage Fp, il ne retransmet à sa sortie 60b que la partie du spectre, présentée à son entrée 60a, qui se situe à (ou aux alentours immédiats) de cette fréquence Fp.

Le filtre 60 présente un facteur de qualité Q élevé, signifiant que les niveaux de signal aux fréquences en dehors de la fréquence F sont très rapidement atténués. Plus précisément, le facteur de qualité Q est une mesure de l'acuité du pic à la résonance à la fréquence Fp.

La commande de la fréquence centrale du filtre s'effectue à partir d'une entrée de réglage 60b du filtre reliée au circuit résonant 70 de ce dernier.

Cette entrée de réglage 60c est alimentée par le signal Vref de commande de fréquence de l'oscillateur commandé en tension 20, prélevé à la sortie de filtre passe-bas 26.

Ce signal Vref apparaît donc sous la forme d'une tension, engendrée par le comparateur de phases 24. Il évolue en fonction des sauts de fréquence imposés à l'émetteur et qui sont programmés sur le diviseur de fréquences 22, et des éventuels rattrapages de phase nécessaires pour maintenir constante la fréquence Fp du signal de la porteuse entre les sauts de fréquence.

Le filtre actif passe-bonde réglable en fréquence 60 peut être de conception connue. Dans l'exemple, il est basé sur un amplificateur opérationnel associé à un circuit résonnant 70 réalisé à partir de capacités et d'inducteurs, connu sous le nom de circuit résonnant LC.

La fréquence de résonance du circuit résonnant établit la fréquence à laquelle le filtre est accordé. Dans le cas d'un filtre passe-bande, cette fréquence de résonance correspond donc à la fréquence centrale de passage de signal du filtre.

La fréquence de résonance est réglable au moyen de diodes, connus sous le terme de varactors, présentant une capacité variable en fonction de leur tension de polarisation. Ces diodes constituent une partie ou la totalité de la composante capacitive du circuit résonnant LC.

La tension Vref est appliquée en tant que tension de polarisation des diodes varactors.

Le circuit oscillateur commandé en tension 20 comprend également un circuit résonnant 70 LC à fréquence de résonance variable, identique au circuit résonant 70 LC du filtre, mis en circuit dans une boucle à asservissement positif d'un amplificateur. La fréquence de résonance de ce circuit résonnant établit la fréquence d'oscillation de l'oscillateur.

Le circuit résonnant du filtre et le circuit résonnant de l'oscillateur ont ainsi la même fréquence de résonance pour un niveau de tension Vref donné, et ce sur toute la plage de la tension de commande Vref.

Afin d'optimiser l'uniformité des caractéristiques des circuits résonants du filtre et de l'oscillateur, ces circuits sont tous deux intégrés sur un même substrat. De la sorte, les propriétés électriques et physiques du substrat, qui peuvent présenter des dispersions en fabrication ou dans le temps, ne peuvent déséquilibrer les caractéristiques des deux circuits résonants.

La réponse du filtre à fréquence de filtrage réglable 60 de la figure 6 sera maintenant analysée par référence aux figures 7A et 7B. Ces figures représentent le spectre du signal modulé Smod sur la fréquence porteuse Fp respectivement à l'entrée 60a du filtre et à la sortie 60b du filtre, la fréquence centrale de passage du filtre 60 étant réglé, par le signal Vref, afin d'être égale à la fréquence d'émission Fp. Ces deux figures sont à la même échelle et représentent l'intensité du signal en ordonnée et la fréquence en abscisse. Dans les deux figures, l'abscisse est positionnée au niveau d'intensité qui correspond au minimum du spectre avant le filtrage, et qui établit un niveau de référence de comparaison Nbase.

Le spectre du signal Smod avant filtrage (figure 7A) est semblable à celui représenté à la figure 5A. En effet, le signal Smod à ce stade est issu d'éléments de circuit communs aux figures 1 et 6, à la différence près que dans l'émetteur de la figure 1 le signal Smod traverse en outre un étage préfiltrage en amont par le filtre passe-haut 48. Cependant, ce filtre 48 n'atténue que les composantes du spectre de très haute fréquence, de l'ordre de deux à trois fois la fréquence de transmission, et n'apporte pratiquement aucune modification aux fréquences du spectre ici considéré.

On remarque que le spectre du signal Smod avant filtrage est symétrique autour de la fréquence centrale d'émission Fp, qu'il présente un pic très aigu P à cette fréquence et que le niveau au voisinage de ce pic s'établit très rapidement au niveau de référence Nbase après quelques ondulations harmoniques H.

Après filtrage par le filtre à fréquence réglable 60, le spectre maintient son pic P à la fréquence centrale d'émission Fp sensiblement au même niveau Np. La symétrie de ce pic P est également maintenue. Cependant, conformément aux caractéristiques du filtre passe-bande à facteur Q élevé, les composantes de fréquence se situant en dehors de l'enveloppe étroite de transmission E du filtre (représentée en pointillées) sont éliminées. Cette enveloppe E est d'autant plus étroite, et ses pentes d'autant plus raides que le facteur de qualité du filtre est élevé.

On remarque à la figure 7B que l'enveloppe de transmission E présente un maximum très élevé à la fréquence de filtrage Fp, et englobe symétriquement tout le pic P du signal modulé Smod au-dessus du niveau de base Nbase. Elle présente des pentes raides qui descendent rapidement vers un niveau N_{F} très inférieur au niveau de bruit base Nbose. Ainsi, les composantes du spectre du signal d'émission Smod en dehors du pic à la fréquence Fp sont atténuées très rapidement et symétriquement vers ce niveau N_{F}.

Etant symétrique autour de sa fréquence de transmission Fp, le signal Smod issu du filtre 60 peut être amplifié par l'amplificateur de puissance 50 fonctionnant en mode saturé sans que la forme de son spectre soit modifiée par le phénomène de repliement de signal décrit plus haut par référence aux figures 4 et 5. De la sorte, le filtre 60 peut être placé en amont de l'amplificateur de puissance 50. Il remplace avantageusement le filtre passe-bas passif 52 placé en aval de l'amplificateur de puissance 50 selon l'état de la technique représenté par la figure 1.

En conséquence, il est inutile de tenir compte, dans le cahier des charges de l'amplificateur de puissance 50, des pertes de signal liées à un filtre entre cet amplificateur et l'antenne 18.

Aussi, par rapport à l'émetteur de la figure 1, l'émetteur de la figure 6 conforme à la présente invention permet de mettre en oeuvre un amplificateur de puissance 50 à puissance de sortie moins élevée, et donc de plus faible consommation, pour un même niveau de puissance à l'antenne d'émission 18. Cette réduction de consommation permet d'augmenter l'autonomie en temps de conversation d'un terminal de téléphone mobile qui met en oeuvre un tel émetteur.

La figure 8 illustre un exemple de positionnement, vis-à-vis de la bande d'émission Tx, du spectre du signal d'émission Smod de l'émetteur 100 de la figure 6 tel qu'il apparaît à l'antenne 18. Dans cette figure, la bande d'émission Tx correspond à celle allouée à la téléphonie mobile conformément à la norme GSM, déjà décrite plus haut par référence à la figure 2.

Dans l'exemple représenté, le spectre S1 du signal d'émission Smod (représenté en traits pleins) est centré sur une fréquence d'émission Fp, programmée à la boucle de verrouillage de phase 10, qui se trouve correspondre à un canal d'émission proche de ou à la limite supérieure de la bande de transmission Tx. On remarque que le filtrage réalisé conformément à l'invention permet d'éliminer efficacement le bruit, et notamment le bruit de plancher en dehors de cette bande même lorsque le canal de transmission est à la limite supérieure de la bande de transmission.

Ainsi que le montrent les spectres 52 et 53 représentés en pointillés, la forme du spectre de réponse du filtre reste sensiblement la même quelle que soit la fréquence d'émission Fp de l'émetteur 100 dans le bande Tx. Seule sa position évolue, de sorte que la fréquence centrale du spectre se situe automatiquement à la fréquence d'émission Fp commandée sur l'oscillateur 20 par le signal de commande Vref.

L'invention n'est nullement limitée à l'exemple de mode de réalisation venant d'être décrit, son contexte s'étendant à toutes les applications faisant appel à un oscillateur associé à un filtre accordé à la fréquence de l'oscillateur.

Par ailleurs, il est envisageable, tout en restant dans le cadre de l'invention, d'accorder la fréquence du filtre réglable avec le signal de commande de l'oscillateur après un traitement visant une mise en forme ou une adaptation de ce signal pour le rendre compatible avec le filtre. Ceci pourra être le cas notamment lorsque des différences existent entre la réalisation des circuits résonnants du filtre et de l'oscillateur, ou lorsqu'il est nécessaire de tenir compte de modes de fonctionnement spécifiq ues.

On remarque également que le signal de commande de fréquence du filtre et de l'oscillateur peut se présenter sous une forme autre qu'une tension variable, pouvant être par exemple un signal de courant ou d'impédance variable, voire même un signal numérique.

De plus, dans le cas d'une mise en oeuvre de l'invention dans un émetteur, celui ci peut être basé sur toute sorte de modulation, pouvant s'agir de transmissions numériques ou analogiques en modulation de fréquence, de phase, d'amplitude, etc.

Enfin, l'invention peut être mise en oeuvre pour des signaux filtrés à des fréquences autres que les hyperfréquences. Elle peut notamment être mise en oeuvre pour des fréquences relativement faibles, par exemple dans la plage de fréquences audio, ou dans la plage de fréquences faibles, moyennes ou élevées.

## Revendications

1. Dispositif (100) pour produire un signal filtré (Smod) à une fréquence (Fp) donnée, comprenant un oscillateur (20) qui est réglable en fréquence pour osciller à cette fréquence donnée au moyen d'un signal (Vref) de commande de fréquence d'oscillation et au moins un filtre (60) réglable pour s'accorder à cette fréquence donnée, le réglage en fréquence de ce filtre étant réalisé à partir du signal (Vref) de commande de fréquence de l'oscillateur.

2. Dispositif émetteur hertzien (100) émettant un signal modulé et filtré (Smod) sur une fréquence d'émission (Fp) donnée, comprenant un moyen formant oscillateur (20) réglable au moyen d'un signal de commande de fréquence (Vref) pour osciller à cette fréquence d'émission, et au moins un filtre (60) pour filtrer le signal modulé, **caractérisé en ce que** ledit filtre (60) est réglable en fréquence de manière à pouvoir s'accorder à la fréquence d'émission (Fp), le réglage en fréquence de ce filtre étant réalisé à partir du signal (Vref) de commande de fréquence de l'oscillateur (20).

3. Dispositif selon la revendication 1 ou 2, **caractérisé en ce que** le filtre (60) est un filtre actif.

4. Dispositif selon l'une quelconque des revendications 1 à 3, **caractérisé en ce que** le filtre (60) est un filtre passe-bande dont la fréquence centrale de passage de signal est accordée au moyen du signal de commande (Vref).

5. Dispositif selon la revendication 4, **caractérisé en ce que** le filtre (60) a une courbe de réponse sensiblement symétrique autour de la fréquence centrale de passage de signal.

6. Dispositif selon la revendication 4 ou 5, **caractérisé en ce que** le filtre (60) possède un facteur de qualité Q élevé à la fréquence centrale réglable.

7. Dispositif selon l'une quelconque des revendications 1 à 6, **caractérisé en ce que** l'oscillateur (20) est un oscillateur à fréquence asservi en tension mis en oeuvre dans une boucle à verrouillage de phase (10), le signal de commande de fréquence (Vref) étant engendré par un comparateur de phase (24).

8. Dispositif selon l'une quelconque des revendications 1 à 7, **caractérisé en ce que** le filtre (60) et l'oscillateur (20) sont tous les deux réalisés sous forme de circuit intégré sur un même substrat.

9. Dispositif selon l'une quelconque des revendications 1 à 8, **caractérisé en ce que** le filtre (60) et l'oscillateur (20) comprennent chacun des moyens (70) de conversion du signal de commande de fréquence (Vref) en paramètre agissant sur la caractéristique de fréquence, ces moyens étant réalisés selon les mêmes règles de conception.

10. Dispositif selon la revendication 9, **caractérisé en ce que** les moyens de conversion du signal de commande de fréquence (Vref) en paramètre agissant sur la caractéristique de fréquence comprennent au moins un circuit résonnant (70) ayant au moins un composant dont une caractéristique varie en fonction du signal de commande qui lui est présenté, tel qu'une diode dont la capacité est variable en fonction de sa tension de polarisation.

11. Dispositif selon l'une quelconque des revendications 2 à 10, dans lequel l'émetteur (100) comprend un amplificateur de puissance (50) destiné à attaquer une antenne d'émission (18), **caractérisé en ce que** ledit filtre réglable (60) est placé avant l'amplificateur de puissance de l'émetteur.

12. Dispositif selon l'une quelconque des revendications 2 à 11, **caractérisé en ce que** l'émetteur (100) est un émetteur du type sans fréquences intermédiaires.

13. Terminal de téléphone mobile comprenant un dispositif émetteur hertzien conformément à l'une quelconque des revendications 2 à 12.

14. Procédé pour produire un signal filtré (Smod) à une fréquence (Fp) donnée, comprenant l'étape de régler un oscillateur (20) réglable en fréquence ou moyen d'un signal de commande de fréquence d'oscillation (Vref) pour le faire osciller à cette fréquence donnée et l'étape de régler au moins un filtre réglable (60) afin que celui-ci soit accordé à cette fréquence donnée, le réglage en fréquence de ce filtre étant réalisé à partir du signal de commande de fréquence de l'oscillateur.

15. Procédé d'émission d'un signal (Smod) par un dispositif émetteur hertzien selon l'une quelconque des revendications 2 à 12, comprenant l'étape de régler l'oscillateur (20) réglable en fréquence au moyen d'un signal de commande de fréquence d'oscillation (Vref) pour le faire osciller à la fréquence d'émission (Fp) de l'émetteur et l'étape de régler le filtre réglable (60) afin que celui-ci soit accordé à cette fréquence donnée pour laisser passer le signal d'émission (Smod), le réglage en fréquence de ce filtre étant réalisé à partir du signal (Vref) de commande de fréquence de l'oscillateur.

16. Procédé d'émission selon la revendication 15, dans lequel on amplifie le signal d'émission (Smod) par un amplificateur de puissance (50) pour attaquer une antenne d'émission (18), **caractérisé en ce que** l'étape de filtrage du filtre réglable (60) est effectué avant cette amplification en puissance.

## Patentansprüche

1. Vorrichtung (100) zur Erzeugung eines gefilterten Signals (Smod) mit einer gegebenen Frequenz (Fp), die einen Oszillator (20), dessen Frequenz mittels eines Signals (Vref) zur Steuerung der Oszillationsfrequenz geregelt werden kann, um mit dieser gegebenen Frequenz zu schwingen, sowie mindestens ein Filter (60) umfasst, das regelbar ist, um auf diese gegebene Frequenz abgestimmt werden zu können, wobei die Frequenzregelung dieses Filters aufgrund des Signals (Vref) zur Steuerung der Frequenz des Oszillators erfolgt.

2. Funksender (100), der auf einer gegebenen Sendefrequenz (Fp) ein moduliertes und gefiltertes Signal (Smod) sendet und über ein Mittel verfügt, das einen Oszillator (20) bildet, der mittels eines Steuersignals der Frequenz (Vref) regelbar ist, um mit dieser Sendefrequenz zu schwingen, sowie über mindestens ein Filter (60), um das modulierte Signal zu filtern, **dadurch gekennzeichnet, dass** die Frequenz des genannten Filters (60) regelbar ist, um auf die Sendefrequenz (Fp) abgestimmt werden zu können, und die Frequenzregelung dieses Filters aufgrund des Signals (Vref) zur Steuerung der Frequenz des Oszillators (20) erfolgt.

3. Vorrichtung gemäß Anspruch 1 oder 2, **dadurch gekennzeichnet, dass** das Filter (60) ein aktives Filter ist.

4. Vorrichtung gemäß einem der Ansprüche 1 bis 3, **dadurch gekennzeichnet, dass** das Filter (60) ein Bandpassfilter ist, dessen Mittenfrequenz des Signaldurchgangs mittels des Steuersignals (Vref) abgestimmt wird.

5. Vorrichtung gemäß Anspruch 4, **dadurch gekennzeichnet, dass** das Filter (60) eine deutlich symmetrische Kennlinie um die Mittenfrequenz des Signaldurchgangs herum aufweist.

6. Vorrichtung gemäß Anspruch 4 oder 5, **dadurch gekennzeichnet, dass** das Filter (60) bei der regelbaren Mittenfrequenz einen hohen Gütefaktor besitzt.

7. Vorrichtung gemäß einem der Ansprüche 1 bis 6, **dadurch gekennzeichnet, dass** der Oszillator (20) ein Oszillator mit spannungsgesteuerter Frequenz ist, der in einem Phasenregelkreis (10) verwendet wird, wobei das Steuersignal der Frequenz (Vref) durch einen Phasenkomparator (24) erzeugt wird.

8. Vorrichtung gemäß einem der Ansprüche 1 bis 7, **dadurch gekennzeichnet, dass** das Filter (60) und der Oszillator (20) beide in Form einer integrierten Schaltung auf demselben Träger ausgeführt sind.

9. Vorrichtung gemäß einem der Ansprüche 1 bis 8, **dadurch gekennzeichnet, dass** das Filter (60) und der Oszillator (20) jeweils über Mittel (70) zur Umwandlung des Steuersignals der Frequenz (Vref) in einen Parameter verfügen, der auf die Frequenzcharakteristik einwirkt, wobei diese Mittel nach denselben Konstruktionsregeln ausgeführt sind.

10. Vorrichtung gemäß Anspruch 9, **dadurch gekennzeichnet, dass** die Mittel zur Umwandlung des Steuersignals der Frequenz (Vref) in einen Parameter, der auf die Frequenzcharakteristik einwirkt, mindestens einen Resonanzkreis (70) mit mindestens einer Komponente aufweisen, von der eine Charakteristik sich in Abhängigkeit von dem ihr übermittelten Steuersignal ändert, wobei es sich beispielsweise um eine Diode handelt, deren Kapazität in Abhängigkeit von ihrer Potarisationsspannung variabel ist.

11. Vorrichtung gemäß einem der Ansprüche 2 bis 10, wobei der Sender (100) über einen Leistungsverstärker (50) verfügt, um eine Sendeantenne (18) anzusprechen, **dadurch gekennzeichnet, dass** das genannte regelbare Filter (60) dem Leistungsverstärker des Senders vorgeschaltet ist.

12. Vorrichtung gemäß einem der Ansprüche 2 bis 11, **dadurch gekennzeichnet, dass** der Sender (100) ein Sender ohne Zwischenfrequenzen ist.

13. Mobiltelefon mit einem Funksender gemäß einem der Ansprüche 2 bis 12.

14. Verfahren zur Erzeugung eines gefilterten Signals (Smod) mit einer gegebenen Frequenz (Fp), das die Stufe zur Regelung eines Oszillators (20), dessen Frequenz mittels eines Steuersignals der Oszillationsfrequenz (Vref) regelbar ist, um diesen mit dieser gegebenen Frequenz schwingen zu lassen, sowie die Stufe zur Regelung mindestens eines regelbaren Filters (60) umfasst, damit dieses auf diese gegebene Frequenz abgestimmt wird, wobei die Frequenzregelung dieses Filters aufgrund des Steuersignals der Frequenz des Oszillators erfolgt.

15. Verfahren zum Aussenden eines Signals (Smod) durch einen Funksender gemäß einem der Ansprüche 2 bis 12, das die Stufe zur Regelung des Oszillators (20), dessen Frequenz mittels eines Steuersignals der Oszillationsfrequenz (Vref) regelbar ist, um diesen mit der Sendefrequenz (Fp) des Senders schwingen zu lassen, sowie die Stufe zur Regelung des regelbaren Filters (60) umfasst, damit dieses auf diese gegebene Frequenz abgestimmt wird, um das Sendesignal (Smod) durchzulassen, wobei die Frequenzregelung dieses Filters aufgrund des Signals (Vref) zur Steuerung der Frequenz des Oszillators erfolgt.

16. Sendeverfahren gemäß Anspruch 15, bei dem das Sendesignal (Smod) durch einen Leistungsverstärker (50) verstärkt wird, um eine Sendeantenne (18) anzusprechen, **dadurch gekennzeichnet, dass** die Filterung durch das regelbare Filter (60) vor dieser Leistungsverstärkung erfolgt.

## Claims

1. A system (100) for producing a filtered signal (Smod) at a given frequency (F_{P}), including an oscillator (20) whose frequency can be varied by an oscillation frequency control signal (Vref) to cause it to oscillate at the given frequency and at least one filter (60) which can be tuned to the given frequency, wherein the frequency of the filter is varied by the frequency control signal (Vref) of the oscillator.

2. A radio transmitter system (100) for transmitting a modulated and filtered signal (Smod) at a given transmit frequency (F_{P}), the transmitter system including an oscillator (20) whose frequency can be varied by an oscillation frequency control signal (Vref) to cause it to oscillate at the given transmit frequency and at least one filter (60) for filtering the modulated signal, **characterized in that** the frequency of said filter (60) can be varied so that it can be tuned to the given transmit frequency (F_{P}) and the frequency of the filter is varied by the frequency control signal (Vref) of the oscillator (20).

3. A system according to claim 1 or claim 2, **characterized in that** the filter (60) is an active filter.

4. A system according to any one of claims 1 to 3, **characterized in that** the filter (60) is a band-pass filter in which the center frequency of the signal pass-band is tuned by means of the control signal (Vref).

5. A system according to claim 4, **characterized in that** the filter (60) has a response curve that is substantially symmetrical about the center frequency of the signal pass-band.

6. A system according to claim 4 or claim 5, **characterized in that** the filter (60) has a high quality factor Q at the variable center frequency.

7. A system according to any one of claims 1 to 6, **characterized in that** the oscillator (20) is a voltage-controlled oscillator in a phase-locked loop (10) and the frequency control signal (Vref) is generated by a phase comparator (24).

8. A system according to any one of claims 1 to 7, **characterized in that** the filter (60) and the oscillator (20) are both implemented in integrated circuit form on the same substrate.

9. A system according to any one of claims 1 to 8, **characterized in that** the filter (60) and the oscillator (20) include converter means (70) for converting the frequency control signal (Vref) into a parameter operating on the frequency characteristic and their respective converter means are subject to the same design rules.

10. A system according to claim 9, **characterized in that** the converter means for converting the frequency control signal (Vref) into a parameter operating on the frequency characteristic include at least one resonant circuit (70) having at least one component which has a characteristic that varies as a function of the control signal applied to it, such as a diode whose capacitance varies as a function of its bias voltage.

11. A system according to any one of claims 2 to 10, wherein the transmitter (100) includes a power amplifier (50) having a transmit antenna (18) and **characterized in that** said filter (60) is on the input side of the power amplifier of the transmitter.

12. A system according to any one of claims 2 to 11, **characterized in that** the transmitter (100) is a transmitter with no intermediate frequency.

13. A mobile telephone terminal including a radio transmitter according to any one of claims 2 to 12.

14. A method of producing a filtered signal (Smod) at a given frequency (F_{P}) including the step of varying the frequency of a variable frequency oscillator (20) by means of an oscillation frequency control signal (Vref) to cause it to oscillate at a given frequency and the step of varying the frequency of at least one variable frequency filter (60) so that it is tuned to the given frequency, wherein the frequency of the filter is varied by the frequency control signal of the oscillator.

15. A method of transmitting a signal (Smod) from a radio transmitter according to any one of claims 2 to 12, the method including a step of varying the frequency of the variable frequency oscillator (20) by means of an oscillation frequency control signal (Vref) to cause it to oscillate at the transmit frequency (F_{P}) of the transmitter and a step of varying the frequency of the variable filter (60) so that it is tuned to the given frequency to pass the transmit signal (Smod), wherein the frequency of the filter is varied by the frequency control signal (Vref) of the oscillator.

16. A transmission method according to claim 15, wherein the transmit signal (Smod) is amplified by a power amplifier (50) to drive a transmit antenna (18) and **characterized in that** the step of filtering by the variable filter (60) is effected before power amplification.
